## Europäisches Patentamt
## European Patent Office
## Office européen des brevets

(19)

(11) Publication number: **0 134 599 B1**

# EUROPEAN PATENT SPECIFICATION

(12)

(45) Date of publication of patent specification: **19.10.88**

(21) Application number: **84200947.4**

(22) Date of filing: **29.06.84**

(51) Int. Cl.⁴: **H 01 B 1/22, H 01 J 17/49, H 01 L 49/02, G 02 F 1/133, G 03 F 7/26**

(54) Improved electrically conductive materials for devices.

(30) Priority: **07.07.83 US 511618**

(43) Date of publication of application:
**20.03.85 Bulletin 85/12**

(45) Publication of the grant of the patent:
**19.10.88 Bulletin 88/42**

(84) Designated Contracting States:
**DE FR GB**

(56) References cited:
**EP-A-0 030 604**
**EP-A-0 081 323**
**CH-B- 523 564**
**DE-A-2 303 621**
**FR-A-2 441 647**
**GB-A-2 107 076**
**US-A-3 968 056**
**US-A-4 203 106**

**IEEE TRANSACTIONS ON ELECTRICAL INSULATION, vol. EI-13, no.2, April 1978, Institute of Electrical and Electronics Engineers, N.Y. D.A..BOLON, G.M. Lucas, S.H. Schroeter "Radiation Curable Conductive Ink", pages 116-121.**

(73) Proprietor: **N.V. Philips' Gloeilampenfabrieken Groenewoudseweg 1 NL-5621 BA Eindhoven (NL)**

(72) Inventor: **White, Roger Paul c/o INT. OCTROOIBUREAU B.V. Prof. Holstlaan 6 NL-5656AA Eindhoven (NL)**

(74) Representative: **Auwerda, Cornelis Petrus et al INTERNATIONAAL OCTROOIBUREAU B.V. Prof. Holstlaan 6 NL-5656 AA Eindhoven (NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 134 599 B1

## Description

The present invention is directed to an electrically conductive composition suitable for layer formation in electrophoretic devices, comprising a mixture of an electrically non-conducting photoresist with an electrically conductive material. The invention is in particular related to electrophoretic imaging display (EPID) devices comprising an electrophoretic solution sandwiched between substrates, with electrically conductive portions facing said solution formed on said substrates, but the use of conductive photoresists may be provided in numerous structures for electrodes.

Electrophoretic display devices with control electrodes may be seen, for example, in U.S. patent no. 4,203,106 to Dalisa et. al. This reference provides the background to the type of device for which the present invention is particularly useful.

In such EPID devices, materials used for control electrodes are often either an evaporated aluminium film or an evaporated indium oxide ($In_2O_3$) film. These electrode materials have certain disadvantages. In particular, an aluminium conductive film is highly reflective. Further, these materials have questionable adhesion to insulating materials such as used in EPID devices. Conductor cracking and possible flaking causes open or short circuits in these devices. Also, these materials must be patterned with a photoresist-etching procedure in order to be properly formed.

Of these disadvantages, the most serious are high reflectivity and poor adhesion of the electrode material. In a control grid EPID device this causes the device to resemble a mirror at most viewing angels and reduces the contrast and readability of the device to unacceptable levels. Short circuits render the display unusable.

The present invention seeks to provide electrically conductive photoresists, such as can be used as control grid electrodes in an EPID device, which will obviate the above difficulties.

This problem is solved by providing an electrically conductive composition as described in the opening paragraph, which is further characterized in that the electrically conductive material is carbon powder.

In particular, the formation of a control electrode is an EPID device having the properties of being photosensitive when required, electrically conductive, and black solves the foregoing difficulties.

The essential features of the invention are set forth in independant claims 1 and 2. A preferred feature is the subject of dependant claim 3.

The arrangements of the presently claimed invention may be seen more clearly by reference to the drawing figure when illustrates without limitation an embodiment of the present invention, and wherein:

Figure 1 illustrates an expanded view of the electrode structure in an EPID device, and

Figure 2 illustrates a structure for the control electrode in such device.

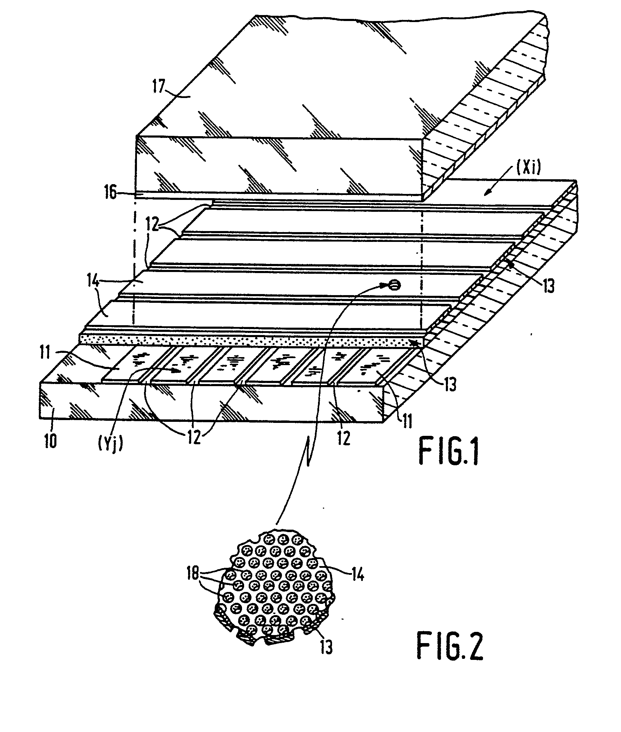

An electrophoretic device with a control grid is constructed generally as seen in Figure 1. In such a structure, a substrate panel 10 is provided on its surface with a plurality of parallel transparent conductive strips adherent to a surface of the substrate, which strips serve as column electrodes 11. Such electrodes may typically be formed of indium oxide applied to the panel by means of a sputtering technique, for example.

The substrate 10 and electrodes 11 are then covered with an insulating layer 13 composed of a photoresist or other dielectric which might be applied by a process of dip coating, for example. A plurality of row electrodes 14 are then adherently applied to the surface of the insulating layer 13 in the form of parallel strips extending transversely to the column electrodes. These row electrodes 14, as well as the underlying insulating layer 13, are then patterned with minute pockets or holes 18 which are shown in an enlarged portion in Figure 2. The holes 18 are not shown in Figure 1 in order to avoid cluttering of the drawing. The row electrodes 14 may act as a control electrode for the EPID device.

A second substrate panel 17 is then provided parallel to the first panel 10 with a plane major surface facing the first panel 10. This surface is coated with an electrode layer 16 which is a continuous transparent electrode layer of indium oxide, for example. An electrophoretic solution (not shown) is placed between the two panels and electrodes.

In such an arrangement for an EPID structure, the present invention enables the control electrode 14 to be formed in a manner to avoid high reflectivity so as to avoid the control electrode from resembling a mirror.

This occurs, for example, by constructing the electrode 14 from a mixture of one part of carbon powder, such as lamp black powder, to two parts of a photoresist material by volume. This combined form is mixed and a conductive photoresist is obtained which is photosensitive, is electrically conductive, and has a black color.

The photoresist material may be a commercial photoresist such as Shipley AZ 1350B. Other examples are AZ 4110 and AZ 1450 of the Azoplate division of American Hoechst Corp.; Kodak 809 and 820 of Kodak Corp.; and Selectilux P of EM Chemicals, all of which are positive type photoresist materials. Negative type photoresists, such as Kodak 747 and Selectilux N, can also be used.

Using such materials as the control electrode in an EPID device, such as that of Figure 1, will achieve conduction as required, as well as provide a non-reflective surface. Moreover, this material of the present invention has an excellent adhesion to the insulating layer 13. Since it is a photoresist, it can be easily patterned in the form of the patterned electrode of Figure 2.

It is highly likely that such a material would be extremely useful for thick film resistors where high curing temperatures, normally used with thick film pastes, are prohibitive. As an example, conductive contacts for materials, such as triglycinesulface or TGS, may provide a good thick film of material according to the invention for infrared radiation detectors.

**Claims**

1. Electrically conductive composition suitable for layer formation in electrophoretic devices comprising a mixture of an electrically non-conducting photoresist with an electrically conductive material, characterized in that the electrically conductive material is carbon powder.

2. An electrophoretic display device comprising an electrophoretic solution sandwiched between substrates, with electrically conductive portions facing said solution formed on said substrates, characterized in that at least one of said electrically conductive portions consists of an electrically conductive composition according to Claim 1.

3. An electrophoretic display device according to Claim 2, characterized in that the electrically conductive composition includes one part powder and two parts photoresist.

**Patentansprüche**

1. Elektrisch leitende Materialien zur Schichtbildung bei elektrophoretischen Einrichtungen mit einem Gemisch aus einem elektrisch nicht leitenden Photoresist und einem elektrisch leitenden Material, dadurch gekennzeichnet, dass das elektrisch leitende Material Kohlenstoffpulver ist.

2. Elektrophoretische Wiedergabeanordnung mit einer zwischen Substraten liegenden elektrophoretischen Lösung, wobei elektrisch leitende Teile der genannten Lösung auf den genannten Substraten zugewandt sind, dadurch gekennzeichnet, dass wenigstens einer der genannten elektrisch leitenden Teile aus einer elektrisch leitenden Zusammensetzung nach Anspruch 1 besteht.

3. Elektrophoretische Wiedergabeanordnung nach Anspruch 2, dadurch gekennzeichnet, dass die elektrisch leitende Zusammensetzung einen Teil Pulver und zwei Teile Photoresist aufweist.

**Revendications**

1. Composition électroconductrice convenant à la formation de couches dans des dispositifs électrophorétiques, comprenant un mélange de photorésist non électroconducteur avec un matériau électroconducteur, caractérisé en ce que le matériau électroconducteur est de la poudre de carbone.

2. Dispositif de reproduction électrophorétique contenant une solution électrophorétique se trouvant entre des substrats, muni de parties électroconductrices disposées en face de la solution formée sur lesdits substrats, caractérisé en ce qu'au moins l'une des parties électroconductrices est constituée par une composition électroconductrice selon la revendication 1.

3. Dispositif de reproduction électrophorétique selon la revendication 2, caractérisé en ce que la composition électroconductrice comprend une partie de poudre et deux parties de photorésist.

FIG.1

FIG.2